# EUROPÄISCHE PATENTANMELDUNG

(11) **EP 1 475 692 A2**
(43) Veröffentlichungstag der Anmeldung: **10.11.2004**
(21) Anmeldenummer: 04010025.7
(22) Anmeldetag: 28.04.2004
(51) Int. Cl.: G06F 3/033

(54) **Berührungsschalteinrichtung**

(30) Priorität: 07.05.2003 DE 10320548
(71) Anmelder: Schott Glas, 55122 Mainz (DE); Carl-Zeiss-Stiftung trading as Schott Glas, 55122 Mainz (DE)
(72) Erfinder: Engelmann, Harry, 55218 Ingelheim (DE)
(74) Vertreter: Fleck, Hermann-Josef, Dr.-Ing.

(57) **Zusammenfassung**

Die Erfindung betrifft eine Berührungsschalteinrichtung mit einer flächigen, elektrisch nichtleitenden Abdeckung (10), welche an der dem Bediener zugewandten Oberseite (12) eine Schaltfläche (14a, 14b) bildet und eine dem Bediener abgewandte Unterseite (16) aufweist, an der mindestens eine Elektrode (18a, 18b; 20a, 20b) angeordnet ist, die mit einer Schaltungsanordnung (22) zum Auslösen eines Berührungssignals bei Annäherung eines Fingers des Bedieners oder dergleichen leitfähigen Körpers an die Schaltfläche (14a, 14b) verbunden ist. Die Abdeckung (10) weist zumindest bereichsweise einen Licht reflektierenden, elektrisch nicht leitenden Film (24) als Dielektrikum auf.

Verwendung beispielsweise bei Bedienblenden von elektronischen Geräten.

## Beschreibung

Die Erfindung betrifft eine Berührungsschalteinrichtung mit einer flächigen, elektrisch nichtleitenden Abdeckung, welche an der dem Bediener zugewandten Oberseite eine Schaltfläche bildet und eine dem Bediener abgewandte Unterseite aufweist, an der mindestens eine Elektrode angeordnet ist, die mit einer Schaltungsanordnung zum Auslösen eines Berührungssignals bei Annäherung eines Fingers des Bedieners oder dergleichen leitfähigen Körpers an die Schaltfläche verbunden ist.

Aus dem Stand der Technik sind kapazitive bzw. auf Basis elektrischer Feldwirkung arbeitende Berührungsschalter bekannt. Diese sind beispielsweise in der US 5,594,222 oder der EP 0 859 467 A1 beschrieben.

Derartige Berührungsschalter werden im allgemeinen eingesetzt, um Schaltvorgänge durch eine durchgängige Fläche aus Glas oder Kunststoff hindurch auslösen zu können. Dazu werden die Berührungsschalter hinter der Fläche, die beispielsweise die Bedienblende für ein elektrisches oder elektrisch ansteuerbares Gerät, eine Glaskeramik-Kochfläche oder eine sonstige Eingabeeinheit darstellt, angeordnet. Durch berühren der Fläche im Bereich des Berührungsschalters wird dann der Schaltvorgang ausgelöst, wobei die eigentliche Schaltfunktion von elektronischen Schaltern oder Relais ausgeführt wird.

Die auf elektrischer Feldwirkung basierenden bzw. kapazitiven Berührungsschalter weisen zumindest eine Elektrode auf, die hinter einer durchgängigen Abdeckung im Bereich der Schaltfläche angeordnet ist. Die Schaltfunktion wird ausgelöst, wenn sich ein ausreichend großer leitfähiger Körper, beispielsweise ein menschlicher Finger, in der Nähe der Elektrode befindet.

Bei nach Stand der Technik gängigen Berührungsschaltern befinden sich zwei Elektroden auf der dem Benutzer abgewandten Seite der Abdeckung. Auf der dem Bediener zugewandten Seite ist eine gegebenenfalls durchsichtige Elektrode angeordnet, welche die beiden unteren Elektroden überdeckt. Die unteren Elektroden werden von einer Elektronik so angesteuert, dass sie als Reihenschaltung zweier Kapazitäten wirken. Die Kopplung erfolgt dabei über die obere Elektrode. Berührt der Bediener die obere Elektrode, wird diese auf Masse gelegt und die Kopplung des Signals wird stark geschwächt.

Aus dem Stand der Technik ist weiterhin ein Berührungsschalter bekannt, bei welchem nur an der Unterseite der Abdeckung zwei Elektroden zueinander benachbart angeordnet sind. Die beiden Elektroden werden so angesteuert, dass ein elektrisches Wechselfeld aufgebaut wird, welches die durchgängige Abdeckung durchdringt. Durch Berühren der Schaltfläche wird das elektrische Wechselfeld gestört. Eine derartige Störung lässt sich dann Mittels einer geeigneten elektrischen Schaltung detektieren.

Die Abdeckung bzw. Fläche darf dabei nicht elektrisch leitfähig sein, da sonst die sich aufbauenden elektrischen Felder abgeschirmt werden würden. Die Abdeckung stellt somit ein Dielektrikum dar.

Aus designerischen Gründen sind oftmals die Bedienflächen insbesondere von elektronischen Geräten als metallische Flächen ausgebildet. Derartige Metalle sind im allgemeinen für elektrische Felder nicht durchlässig, d.h. diese werden durch das Metall abgeschirmt. Daher können die nach Stand der Technik bekannten Berührungsschalter nicht durch geschlossene metallische Flächen hindurch betätigt werden. Dies gilt auch für metallisierte Flächen aus Glas oder transparentem Kunststoff, welche ebenfalls auf elektrische Felder abschirmend wirken.

Eine für elektrische Felder durchlässige Folie wird unter der Bezeichnung "Radiant Mirror Film" von der Firma 3M angeboten. Ein derartiger Film bzw. eine derartige Folie besteht aus mehreren Polymerschichten. Mehr als 95 % des sichtbaren Lichtes im Wellenbereich von 400 bis 700 nm werden bei glatter Ausführung der Folie in einem Einfallswinkel von 0 Grad bis 90 Grad spiegelreflektiert. Der Aufbau und die Funktion eines derartigen polymeren Films ist beispielsweise in der EP 0 962 807 A2 beschrieben. Dabei wird durch einen Schichtaufbau doppelbrechender organischer Materialien eine besonders hohe Lichtreflektion erreicht, was dem Film ein metallisch spiegelndes Aussehen verleiht. Der Film ist nicht leitend und eignet sich daher als Dielektrikum bei kapazitiven bzw. auf elektrischer Feldwirkung basierenden Berührungsschaltern.

Es ist Aufgabe der Erfindung, eine Berührungsschalteinrichtung anzugeben, bei welchem die flächige Abdeckung eine metallische Anmutung besitzt und dennoch die Funktion der Berührungsschalteinrichtung nicht behindert wird.

Die Aufgabe der Erfindung wird durch die Merkmale des Anspruches 1 gelöst. Vorteilhafte Weiterbildungen sind in den Unteransprüchen beschrieben.

Demgemäss weist die Abdeckung zumindest bereichsweise einen Licht reflektierenden, elektrisch nicht leitenden Film als Dielektrikum auf. Ein derartiger Film erscheint dem Bediener aufgrund seiner Reflektionseigenschaften wie eine metallische Fläche, wobei jedoch die elektrischen Felder nicht abgeschirmt werden.

Gemäß einer bevorzugten Ausführungsform ist der Film aus einem mehrlagigen, Licht spiegelnd reflektierenden Polymer-Film gebildet. Ein derartiger Film ist metallfrei und elektrisch nicht leitend. Er lässt sich mit anderen Materialien leicht verbinden, ist flexibel und weist eine nahezu vollständige Lichtreflektion im sichtbaren Bereich auf.

Dabei kann der mehrlagige Polymer-Film mehr als 95% des sichtbaren Lichts im Wellenlängenbereich von λ = 400 nm bis 700 nm reflektieren, wobei aufgrund der doppelbrechenden Eigenschaften der Lagen Licht in einem Einfallswinkel von 0° bis 90° spielgelreflektiert werden kann.

Gemäß einer Ausführungsform der Erfindung sind an der Unterseite der Abdeckung zwei benachbarte untere Elektroden und an der Schaltfläche eine obere Elektrode angeordnet, welche in ihrer Erstreckung die an der Unterseite angeordneten zwei Elektroden überdeckt, die als Reihenschaltung zweier Kapazitäten miteinander verschaltet und über die obere Elektrode miteinander kapazitiv gekoppelt sind. Eine derartige Berührungsschalteinrichtung ist besonders einfach aufgebaut, jedoch ist die obere Elektrode aus designerischen Gründen oftmals störend.

Um hierbei Abhilfe zu schaffen, kann die obere Elektrode aus einem durchsichtigen Material bestehen.

Gemäß einer weiteren bevorzugten Ausführungsform sind an der Unterseite der Abdeckung zwei benachbarte Elektroden angeordnet, die mit einer Schaltungseinrichtung zum Erzeugen eines die Abdeckung zumindest im Bereich der Schaltfläche durchdringenden elektrischen Wechselfeldes und zur Ermittlung von Störungen des elektrischen Wechselfeldes bei Annäherung des Fingers des Bedieners oder eines dergleichen leitfähigen Körpers an die Schaltfläche verbunden sind. Bei einer derartigen Berührungsschalteinrichtung entfällt die obere Elektrode. Die Elektroden sind vor mechanischer Einwirkung hinter der Abdeckung geschützt. Das Design der Oberfläche lässt sich frei gestalten. Weiterhin können bedarfsweise die Elektroden kostengünstig auf einer Elektronikplatine angeordnet sein.

Dabei kann die Abdeckung direkt aus dem Licht reflektierendem Film gebildet sein. Durch Berühren des Films im Bereich der Schaltfläche wird der Schaltvorgang ausgelöst.

Eine besonders robuste Berührungsschalteinrichtung, bei welcher insbesondere die unterhalb der Abdeckung angeordnete Elektronik vor mechanischer Einwirkung und Nässe wirkungsvoll geschützt ist, wird dadurch gebildet, dass die Abdeckung aus einer transparenten Platte gebildet ist, die an der dem Bediener zugewandten Oberseite die Schaltfläche und an der dem Bediener abgewandten Unterseite den Licht reflektierenden Film aufweist. Somit wird der Licht reflektierende Film durch die transparente Platte vor mechanischen Einwirkungen geschützt.

Gemäß einer alternativen Ausführungsform kann die Abdeckung aus einer transparenten Platte gebildet sein, die an der dem Bediener zugewandten Oberseite den Licht reflektierenden Film und die Schaltfläche aufweist.

Um eine sichere Verbindung zwischen dem Licht reflektierendem Film und der transparenten Platte sicherzustellen, kann der Film an der Platte mittels Laminierung, Hitzeversiegelung, Klebung oder dergleichen festen und flächigen Verbindung angebracht sein.

Gemäß einem Aspekt der Erfindung kann die transparente Platte aus Glas, Kunststoff oder dergleichen transparentem Material bestehen. Durch die Transparenz der Platte wird sichergestellt, dass der Blick des Bedieners auf den Licht reflektierenden Film trifft und somit eine metallische Anmutung erzeugt wird.

Unterschiedliche designerische Effekte werden dadurch erreicht, dass der Licht reflektierende Film eine glatte, spiegelnde oder alternativ eine strukturierte, Licht diffus reflektierende Oberfläche aufweist. Somit lässt sich beispielsweise das optische Erscheinungsbild ähnlich einer gebürsteten Edelstahl-Oberfläche erzeugen.

Gemäss einer vorteilhaften Weiterbildung kann der Licht reflektierende Film eine zumindest geringe Transmission für Licht aufweisen. Dies ermöglicht das zumindest teilweise Hinterleuchten des Films mit einer Lichtquelle.

So kann an der dem Bediener abgewandten Unterseite der Abdeckung oder des Licht reflektierten Films eine oder mehrere Leuchtanzeigen angeordnet sein.

Diese Leuchtanzeigen können durch Lampen, Leuchtdioden, selbstleuchtende graphische Anzeigen, 7-Segment-Anzeigen, hinterleuchtete Flüssigkristallanzeigen, hinterleuchtete Symbole oder dergleichen den Licht reflektierenden Film durchstrahlende optische Anzeigen gebildet sein. Mit Hilfe derartiger Anzeigen kann beispielsweise der Schaltzustand der Berührungsschalteinrichtung, deren Position oder aber auch weitere Informationen dargestellt werden.

Auf besonders einfache Weise kann die Lage der Schaltfläche mittels zumindest einer Symbolik oder dergleichen Markierung auf der Abdeckung und/oder auf dem Licht reflektierendem Film gekennzeichnet sein. Dies erleichtert dem Bediener das Auffinden der gewünschten Berührungsschalteinrichtung.

Gemäß einer erfinderischen Weiterbildung kann der Licht reflektierende Film flexibel und die flächige Abdeckung zumindest bereichsweise gebogen, abgewinkelt oder dergleichen von der ebenen Form abweichenden Formgebung ausgebildet sein. Dieses ermöglicht noch zusätzliche designerische Möglichkeiten.

Nachfolgend wird die Erfindung anhand bevorzugter Ausführungsformen unter Bezugnahme auf die beigefügten Zeichnungen näher erläutert.

Es zeigen:

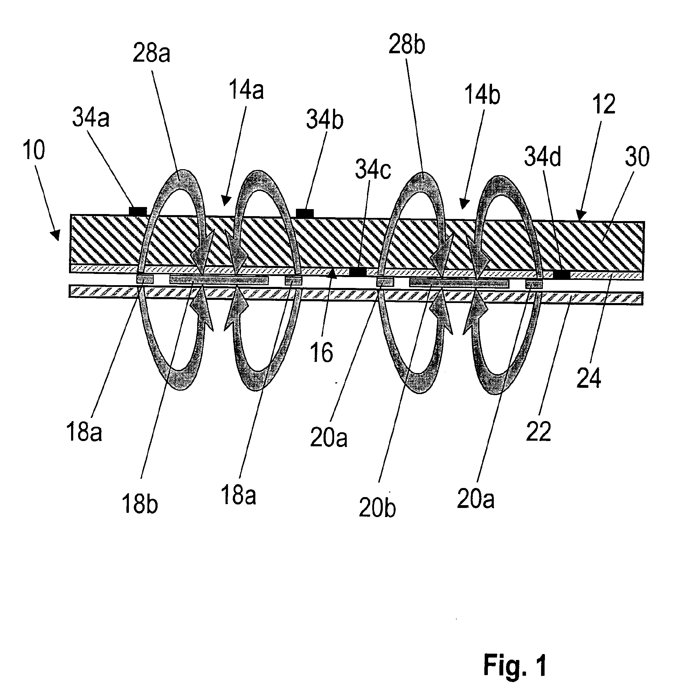

- Figur 1: in schematischer Ansicht und im Schnitt eine Anordnung aus zwei auf elektrischer Feldwirkung basierenden Berührungsschalteinrichtungen gemäß einer ersten Ausführungsform, bei welchen der Licht reflektierende Film an der dem Bediener abgewandten Seite einer transparenten Platte angebracht ist;

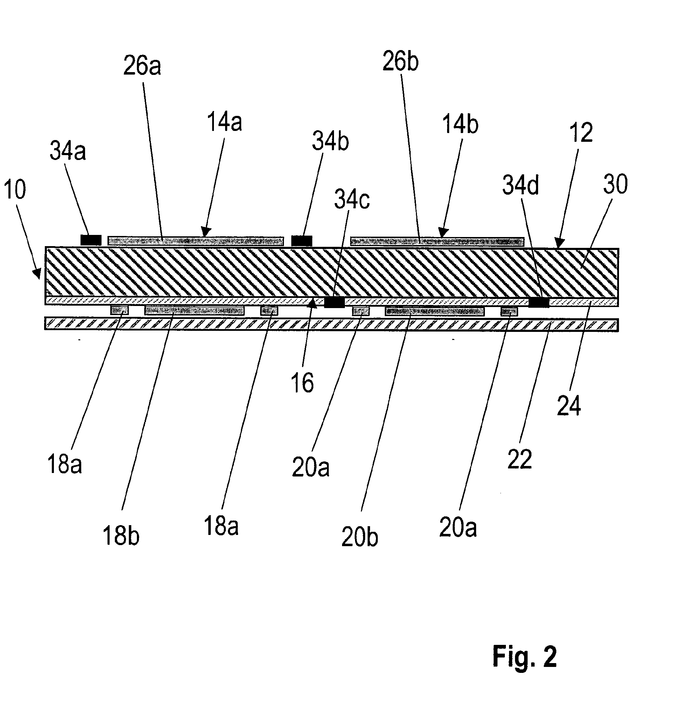

- Figur 2: in schematischer Ansicht und im Schnitt eine Anordnung aus zwei kapazitiven Berührungsschalteinrichtungen gemäß einer weiteren Ausführungsform, bei welchen der Licht reflektierende Film an der dem Bediener abgewandten Seite einer transparenten Platte und an der dem Bediener zugewandten Seite eine zusätzliche Elektrode angebracht ist;

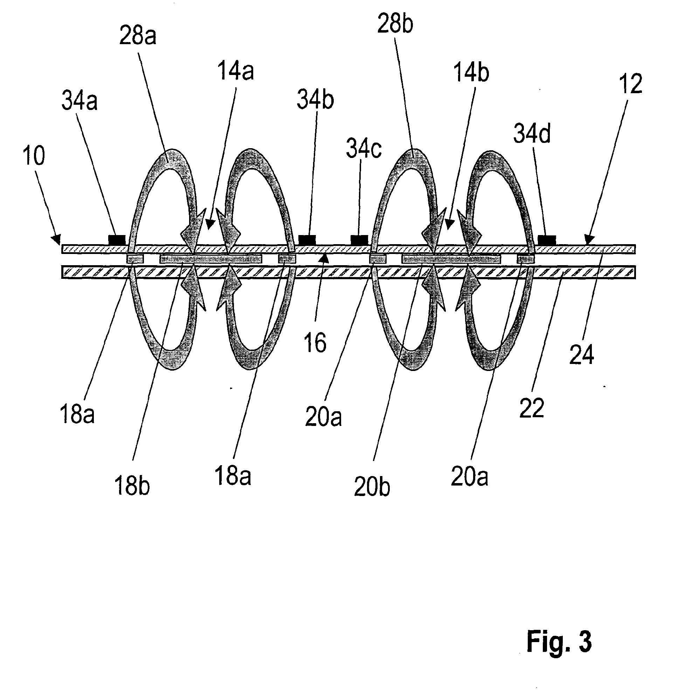

- Figur 3: in schematischer Ansicht und im Schnitt eine Anordnung aus zwei auf elektrischer Feldwirkung basierenden Berührungsschalteinrichtungen gemäß noch einer weiteren Ausführungsform, bei welchen die Abdeckung aus dem Licht reflektierenden Film gebildet ist; und

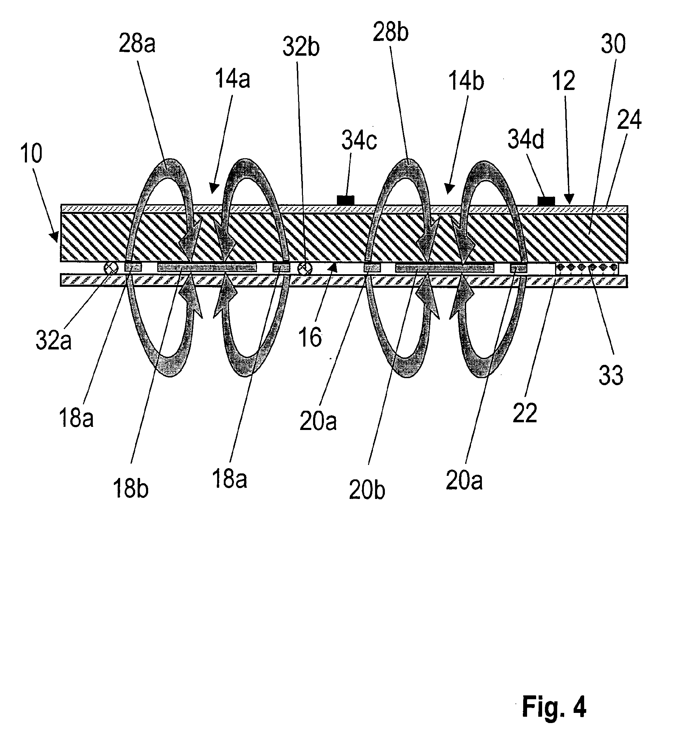

- Figur 4: in schematischer Ansicht und im Schnitt eine Anordnung aus zwei auf elektrischer Feldwirkung basierenden Berührungsschalteinrichtungen gemäß noch einer weiteren Ausführungsform, bei welchen der Licht reflektierende Film an der dem Bediener zugewandten Seite einer transparenten Platte angebracht ist und zusätzliche Leuchtanzeigen integriert sind.

Figur 1 zeigt in schematischer Ansicht und im Schnitt eine Anordnung aus zwei auf elektrischer Feldwirkung basierenden Berührungsschalteinrichtungen gemäß einer ersten Ausführungsform. An einer flächigen, durchgehenden Abdeckung 10 ist an der Oberseite 12 der linken Berührungsschalteinrichtung eine erste Bedienfläche 14a und an der rechten Berührungsschalteinrichtung eine Bedienfläche 14b angeordnet. Die Bedienflächen 14a und 14b sind an einer durchsichtigen, nicht leitenden Platte 30 aus Glas oder Kunststoff angeordnet. An der dem Bediener abgewandten Unterseite der Platte 30 ist ein mehrlagiger Polymer-Film 24 mittels Laminierung angebracht.

Der mehrlagige Polymer-Film kann beispielsweise eine durch die Firma 3M unter der Bezeichnung "Radiant Mirror Film" angebotene Folie sein. Ein derartiger Film bzw. eine derartige Folie besteht aus mehreren Polymerschichten. Mehr als 95 % des sichtbaren Lichtes im Wellenbereich von 400 bis 700 nm werden bei glatter Ausführung der Folie in einem Einfallswinkel von 0 Grad bis 90 Grad spiegelreflektiert. Dabei wird durch einen Schichtaufbau doppelbrechender organischer Materialien eine besonders hohe Lichtreflektion erreicht, was dem Film ein metallisch spiegelndes Aussehen verleiht. Der Film ist nicht leitend und eignet sich daher als Dielektrikum bei kapazitiven bzw. auf elektrischer Feldwirkung basierenden Berührungsschaltern.

Unterhalb des Polymer-Films 24 sind an der Unterseite 16 der Abdeckung 10 jeder Schaltfläche 14a bzw. 14b zwei Elektroden 18a und 18b bzw. 20a und 20b zugeordnet. Die Elektroden 18a, 18b, 20a und 20b liegen flächig an dem Polymer-Film 24 an oder sind nur gering davon beabstandet und erstrecken sich im wesentlichen parallel zum Polymer-Film 24 bzw. zur Platte 30. Die Elektroden 18b und 20b werden ringförmig von den Elektroden 18a bzw. 20a umfasst.

Die beiden Elektroden 18a und 18b bzw. 20a und 20b werden jeweils so angesteuert, dass ein elektrisches Wechselfeld 28a bzw. 28b aufgebaut wird. Die Wechselfelder 28a und 28b durchdringen sowohl den Polymer-Film 24 als auch die Platte 30. Die Elektroden 18a und 18b bzw. 20a und 20b sind auf einer Elektronikleiterplatte 22 angeordnet, welche eine (nicht gezeigte) elektronische Schaltungsanordnung zum Aufbau der elektronischen Wechselfelder 28a und 28b aufweist. Durch Berühren der Schaltfläche 14a wird das elektrische Wechselfeld 28a gestört, welches durch eine ebenfalls auf der Elektronikleiterplatte 22 angeordnete (nicht gezeigte) elektrische Schaltungsanordnung detektiert wird. Dadurch lässt sich ein Schaltvorgang für das anzusteuernde elektronische Gerät auslösen. Bei Berühren der Schaltfläche 14b durch beispielsweise einen Finger des Bedieners wird das elektrische Wechselfeld 28b gestört, wodurch ein Schaltvorgang an der rechten Berührungsschalteinrichtung ausgelöst wird.

Damit der Bediener die Schaltfläche 14a der linken Berührungsschalteinrichtung auf der Platte 30 sicher findet, sind auf der Platte 30 Markierungen 34a und 34b angebracht. Beispielsweise kann die Platte 30 hierzu in geeigneter Weise, beispielsweise mit einem Kreissymbol bedruckt sein.

Alternativ ist die Schaltfläche 14b der rechten Berührungsschalteinrichtung durch Markierungen 34c und 34d gekennzeichnet, welche direkt an dem Polymer-Film 24, d. h. unterhalb der transparenten Platte 30 angebracht sind. Durch diese Anordnung der Markierungen 34c und 34d unterhalb der Platte 30 wird die Oberfläche derselben nicht gestört.

Figur 2 zeigt in schematischer Ansicht und im Schnitt eine Anordnung aus zwei kapazitiven Berührungsschalteinrichtungen gemäß einer weiteren Ausführungsform. An der dem Bediener zugewandten Oberseite 12 weist die transparente Platte 30 im Bereich der linken Berührungsschalteinrichtung eine durch eine obere Elektrode 26a gebildete Schaltfläche 14a auf. Im Bereich der rechten Berührungsschalteinrichtung bildet eine obere Elektrode 26b die Schaltfläche 14b. An der Unterseite 16 der Platte 30 ist der Polymer-Film 24 angebracht. Auf einer ebenfalls an der Unterseite 16 angebrachten Elektronikleiterplatte 22 sind jeder Schaltfläche 14a bzw. 14b Elektroden 18b bzw. 20b zugeordnet. Die oberen Elektroden 26a bzw. 26b überdecken in ihrer Erstreckung die Elektrodenanordnungen bestehend aus den Elektroden 18b und 18a bzw. 20b und 20a. Die Elektroden 26a und 26b sind aus einem durchsichtigen Material aufgebaut.

Die unteren Elektroden 18a und 18b bzw. 20a und 20b werden von einer ebenfalls auf der Elektronikleiterplatte 22 angeordneten (nicht gezeigten) Schaltungsanordnung so angesteuert, dass sie jeweils als Reihenschaltung zweier Kapazitäten wirken. Die Kopplung zwischen den Elektroden 18a und 18b bzw. 20a und 20b erfolgt über die jeweils obere Elektrode 26a bzw. 26b. Wenn der Bediener beispielsweise mit seinem Finger die obere Elektrode 26a der linken Berührungsschalteinrichtung berührt, wird diese auf Masse gelegt und die Kopplung des Signals zwischen den Elektroden 18a und 18b wird stark geschwächt. Hierdurch wird an der linken Berührungsschalteinrichtung ein Schaltvorgang ausgelöst. Ebenso wird durch Berühren der Schaltfläche 14b an der rechten Berührungsschalteinrichtung ein Schaltvorgang ausgelöst.

Die neben der Schaltfläche 14a bzw. der oberen Elektrode 26a angeordneten Markierungen 34a und 34b sollen das Auffinden der Schaltfläche 14a erleichtern. Zu diesem Zwecke sind die Markierungen 34a und 34b auf der Oberseite 12 der Platte 30 aufgedruckt. Alternativ sind die Markierungen 34c und 34d im Umgebungsbereich der Schaltfläche 14b bzw. der Elektrode 26b direkt auf dem Polymer-Film 24 aufgedruckt.

Figur 3 zeigt in schematischer Ansicht und im Schnitt eine Anordnung aus zwei auf elektrischer Feldwirkung basierenden Berührungsschalteinrichtungen gemäß noch einer weiteren Ausführungsform. Demgemäss wird die Abdeckung 10 direkt durch den Polymer-Film 24 gebildet. An der linken Berührungsschalteinrichtung ist eine Schaltfläche 14a, welche durch Markierungen 34a und 34b auf dem Polymer-Film 24 gekennzeichnet ist, auf der Oberseite 12 der Abdeckung 10 angeordnet. In gleicher Weise ist an der rechten Berührungsschalteinrichtung eine Schaltfläche 14b, welche durch die Markierungen 34c und 34d auf dem Polymer-Film 24 gekennzeichnet ist, auf der Oberseite 12 der Abdeckung 10 angeordnet. Auf der Unterseite 16 der Abdeckung 10 bzw. des Polymer-Films 24 sind den Schaltflächen 14a bzw. 14b zugeordnete Elektrodenanordnungen bestehend aus jeweils einer Elektrode 18b bzw. 20b, welche von einer weiteren Elektrode 18a bzw. 20a ringförmig umschlossen wird, angeordnet. Diese Elektrodenanordnungen sind auf einer Elektronikleiterplatte 22 angeordnet, welche noch weitere, bereits anhand der Figur 1 näher erläuterte ( nicht gezeigte) elektronische Schaltungsanordnungen aufweist.

Figur 4 zeigt in schematischer Ansicht und im Schnitt eine Anordnung aus zwei auf elektrischer Feldwirkung basierenden Berührungsschalteinrichtungen gemäß noch einer weiteren Ausführungsform.

Die Figur 4 zeigt im wesentlichen die gleichen Komponenten wie bereits die Figur 1. Diejenigen Komponenten, welche mit denselben Bezugszeichen wie die entsprechenden Komponenten der Figur 1 versehen sind, bezeichnen gleiche oder vergleichbare Komponenten. Somit sollen anhand der Figur 4 nur die Unterschiede gegenüber der in Figur 1 gezeigten und beschriebenen Ausführungsform behandelt werden.

Demgemäss ist der Polymer-Film 24 auf der Oberseite 12 der nicht leitenden Platte 30 aufgebracht. Somit befinden sich die Schaltflächen 14a bzw. 14b direkt auf der Oberseite des Polymer-Films 24. Der Polymer-Film 24 weist eine Resttransmission von ca. 5% für Licht auf. So sind am Randbereich der Schaltfläche 14a der linken Berührungsschalteinrichtung zu deren optischer Begrenzung Leuchtdioden 32a und 32b auf der Elektronikleiterplatte 22 angeordnet, welche die transparente Platte 30 und den Polymer-Film (geschwächt) durchstrahlen.

Die Schaltfläche 14b der rechten Berührungsschalteinrichtung wird durch auf dem Polymer-Film 24 aufgedruckten Markierungen 34c und 34d gekennzeichnet. Rechts neben der Schaltfläche 14b ist an der Unterseite 16 der Abdeckung 10 eine separat ansteuerbare 7-Segment-Anzeige angeordnet. Diese dient dazu, dem Benutzer anzuzeigen, welchen Temperaturwert er an der rechten Berührungsschalteinrichtung eingestellt hat. Dabei kann beispielsweise durch länger andauerndes Berühren der rechten Berührungsschalteinrichtung ein erhöhter Wert eingestellt werden.

Mögliche Anzeigen sind weiterhin Leuchtdioden, selbstleuchtende graphische Anzeigen, hinterleuchtete Anzeigen wie hinterleuchtete Flüssigkristallanzeigen, hinterleuchtete Symbole und dergleichen optische Anzeigeeinrichtungen. Diese können beispielsweise als Statusanzeige für den Betriebszustand des elektrischen Gerätes, welches mit der Berührungsschalteinrichtung bedient wird, dienen. Weiterhin kann die Schaltfläche, deren Position sowie der jeweilige Schaltzustand beispielsweise durch Farbwechsel angezeigt werden. Auch sind Hinterleuchtungen zu reinen Designzwecken, beispielsweise leuchtende Schriftzüge, denkbar.

Bei allen vorstehen beschriebenen Ausführungsformen kann der Polymer-Film 24 auf unterschiedliche Weise, beispielsweise durch Laminierung oder Klebeverbindung mit der Platte 30 verbunden werden. Zusätzlich kann der Polymer-Film 24 hitzeversiegelt ausgebildet sein.

Um unterschiedliche metallische Anmutungen zu erzeugen, kann der Polymer-Film 24 glatt sein, um eine glatt spiegelnde Fläche darzustellen. Alternativ kann jedoch der Polymer-Film 24 strukturiert sein, um ein anderes optisches Erscheinungsbild, beispielsweise ähnlich einer gebürsteten Edelstahloberfläche mittels diffuser Reflektion zu erreichen.

Gemäss noch einer weiteren nicht gezeigten Ausführungsform ist der Polymer-Film flexibel ausgebildet, so dass auch mit Hilfe beispielsweise gebogener Platten gebogene Bedienblenden ausebildet werden können.

## Patentansprüche

1. Berührungsschalteinrichtung mit einer flächigen, elektrisch nichtleitenden Abdeckung (10), welche an der dem Bediener zugewandten Oberseite (12) eine Schaltfläche (14a, 14b) bildet und eine dem Bediener abgewandte Unterseite (16) aufweist, an der mindestens eine Elektrode (18a, 18b; 20a, 20b) angeordnet ist, die mit einer Schaltungsanordnung (22) zum Auslösen eines Berührungssignals bei Annäherung eines Fingers des Bedieners oder dergleichen leitfähigen Körpers an die Schaltfläche (14a, 14b) verbunden ist,
**dadurch gekennzeichnet, dass**
die Abdeckung (10) zumindest bereichsweise einen Licht reflektierenden, elektrisch nicht leitenden Film (24) als Dielektrikum aufweist.

2. Berührungsschalteinrichtung nach Anspruch 1,
**dadurch gekennzeichnet, dass**
der Film (24) aus einem mehrlagigen, Licht spiegelnd reflektierenden Polymer-Film gebildet ist.

3. Berührungsschalteinrichtung nach Anspruch 2,
**dadurch gekennzeichnet, dass**
der mehrlagige Polymer-Film mehr als 95% des sichtbaren Lichts im Wellenlängenbereich von λ = 400 nm bis 700 nm reflektiert.

4. Berührungsschalteinrichtung nach Anspruch 2 oder 3,
**dadurch gekennzeichnet, dass**
der mehrlagige Polymer-Film Licht in einem Einfallswinkel von 0° bis 90° spielgelreflektiert.

5. Berührungsschalteinrichtung nach einem der Ansprüche 1 bis 4,
**dadurch gekennzeichnet, dass**
an der Unterseite (16) der Abdeckung (10) zwei benachbarte untere Elektroden (18a und 18b; 20a und 20b) und an der Schaltfläche (14a, 14b) eine obere Elektrode (26a, 26b) angeordnet sind, welche in ihrer Erstreckung die an der Unterseite (16) angeordneten zwei Elektroden (18a und 18b; 20a und 20b) überdeckt, die als Reihenschaltung zweier Kapazitäten miteinander verschaltet und über die obere Elektrode (26a; 26b) miteinander kapazitiv gekoppelt sind.

6. Berührungsschalteinrichtung nach Anspruch 5,
**dadurch gekennzeichnet, dass**
die obere Elektrode (26a; 26b) aus einem durchsichtigen Material besteht.

7. Berührungsschalteinrichtung nach einem der Ansprüche 1 bis 4,
**dadurch gekennzeichnet, dass**
an der Unterseite (16) der Abdeckung (10) zwei benachbarte Elektroden (18a und 18b; 20a und 20b) angeordnet sind, die mit einer Schaltungsanordnung (22) zum Erzeugen eines die Abdeckung (10) zumindest im Bereich der Schaltfläche (14a, 14b) durchdringenden elektrischen Wechselfeldes (28a, 28b) und zur Ermittlung von Störungen des elektrischen Wechselfeldes (28a, 28b) bei Annäherung des Fingers des Bedieners oder eines dergleichen leitfähigen Körpers an die Schaltfläche (14a, 14b) verbunden sind.

8. Berührungsschalteinrichtung nach einem der Ansprüche 1 bis 7,
**dadurch gekennzeichnet, dass**
die Abdeckung aus dem Licht reflektierenden Film (24) gebildet ist.

9. Berührungsschalteinrichtung nach einem der Ansprüche 1 bis 8,
**dadurch gekennzeichnet, dass**
die Abdeckung (10) aus einer transparenten Platte (30) gebildet ist, die an der dem Bediener zugewandten Oberseite (12) die Schaltfläche (14a, 14b) und an der dem Bediener abgewandten Unterseite (16) den Licht reflektierenden Film (24) aufweist.

10. Berührungsschalteinrichtung nach einem der Ansprüche 1 bis 9,
**dadurch gekennzeichnet, dass**
die Abdeckung (10) aus einer nichtleitenden Platte (30) gebildet ist, die an der dem Bediener zugewandten Oberseite (12) den Licht reflektierenden Film (24) und die Schaltfläche (14) aufweist.

11. Berührungsschalteinrichtung nach Anspruch 9 oder 10,
**dadurch gekennzeichnet, dass**
der Licht reflektierenden Film (24) an der transparenten Platte (30) mittels Laminierung, Hitzeversiegelung, Klebung oder dergleichen festen und flächigen Verbindung angebracht ist.

12. Berührungsschalteinrichtung nach einem der Ansprüche 9 bis 11,
**dadurch gekennzeichnet, dass**
die transparenten Platte (30) aus Glas, Kunststoff oder dergleichen transparentem Material besteht.

13. Berührungsschalteinrichtung nach einem der Ansprüche 1 bis 12,
**dadurch gekennzeichnet, dass**
der Licht reflektierenden Film (24) eine glatte, spiegelnde oder eine strukturierte, Licht diffus reflektierende Oberfläche aufweist.

14. Berührungsschalteinrichtung nach einem der Ansprüche 1 bis 13,
**dadurch gekennzeichnet, dass**
der Licht reflektierenden Film (24) eine zumindest geringe Transmission für Licht aufweist.

15. Berührungsschalteinrichtung nach Anspruch 14,
**dadurch gekennzeichnet, dass**
an der dem Bediener abgewandten Unterseite (16) der Abdeckung (10) oder des Licht reflektierenden Films (24) eine oder mehrere Leuchtanzeigen (32a, 32b, 32c) angeordnet sind.

16. Berührungsschalteinrichtung nach Anspruch 15,
**dadurch gekennzeichnet, dass**
die Leuchtanzeigen (32a, 32b) durch Lampen, Leuchtdioden, selbstleuchtende graphische Anzeigen, 7-Segment-Anzeigen (33), hinterleuchtete Flüssigkristallanzeigen, hinterleuchtete Symbole oder dergleichen den Licht reflektierenden Film durchstrahlende optische Anzeigen gebildet sind.

17. Berührungsschalteinrichtung nach einem der Ansprüche 1 bis 16,
**dadurch gekennzeichnet, dass**
die Lage der Schaltfläche (14a, 14b) mittels zumindest einer Symbolik oder dergleichen Markierung (34a, 34b, 34c, 34d) auf der Abdeckung (10) und/oder auf dem Licht reflektierenden Film (24) gekennzeichnet ist.

18. Berührungsschalteinrichtung nach einem der Ansprüche 1 bis 17,
**dadurch gekennzeichnet, dass**
der Licht reflektierenden Film (24) flexibel und die flächige Abdeckung (10) zumindest bereichsweise gebogen, abgewinkelt oder dergleichen von der ebenen Form abweichenden Formgebung ausgebildet ist.
